# EUROPÄISCHE PATENTSCHRIFT

(11) **EP 2 384 422 B1**
(45) Veröffentlichungstag und Bekanntmachung des Hinweises auf die Patenterteilung: **29.05.2013**
(21) Anmeldenummer: 10724485.7
(22) Anmeldetag: 04.06.2010
(51) Int. Cl.: G01D 4/00

(54) **MEHRFACHSTROMZÄHLERMODUL**
MULTIPLE ELECTRIC-SUPPLY METER MODULE
MODULE DE COMPTEUR DE COURANT MULTIPHASÉ

(30) Priorität: 05.06.2009 DE 102009024301
(43) Veröffentlichungstag der Anmeldung: 09.11.2011
(73) Patentinhaber: Mangelberger, Jürgen, 91126 Schwabach (DE)
(72) Erfinder: MANGELBERGER, Jürgen, 91126 Schwabach (DE); MANGELBERGER, Philip, 91126 Schwabach (DE)
(74) Vertreter: Simon, Josef
(86) Internationale Anmeldenummer: PCT/EP2010/057811
(87) Internationale Veröffentlichungsnummer: WO 2010/139779

(56) Entgegenhaltungen:
- DE-A1-102007 017 985
- US-B1- 6 538 577

## Beschreibung

Die Erfindung betrifft ein Mehrfachstromzählermodul.

Zur Erfassung des Stromverbrauchs in einem Gebäude werden Stromzähler eingesetzt, die als Direktzähler oder Impulszähler ausgebildet sein können. Mit derartigen Stromzählern wird der Stromverbrauch, gegebenenfalls auch die elektrische Leistung, gemessen. Im einfachsten Fall besitzt der Stromzähler eine Anzeige, auf der die gesamte verbrauchte elektrische Energie abgelesen werden kann. Daneben sind Stromzähler bekannt, die die gemessene Energie oder Leistung über eine Leitungsverbindung an ein von dem Stromzähler entfernt angeordnetes Gerät übertragen können.

Um den Verbrauch von elektrischer Energie zu senken, ist es zunächst erforderlich, den Stromverbrauch zu erfassen, um wirksame Maßnahmen zur Energieeinsparung vornehmen zu können. Bei gewerblich genutzten Gebäuden ist es wünschenswert, die einzelnen elektrischen Verbraucher separat zu erfassen, um die einzelnen Verbräuche einer Kostenstelle zuordnen zu können. Dazu wird bisher für jede Gruppe von Verbrauchern ein einzelner, separater Stromzähler verwendet. Bei einem gewerblich genutzten Gebäude kann beispielsweise jeweils ein Stromzähler für die Beleuchtung, die Klimaanlage, Elektrogeräte in einer Küche oder für elektrisch angetriebene Produktionsmaschinen vorgesehen sein. Nachteilig ist dabei, dass herkömmliche Stromzähler sehr viel Platz in einer Elektroverteilung, die normalerweise in einem Installationsschrank eingebaut ist, benötigen. Besonders unübersichtlich wird die Erfassung des Stromverbrauchs bei größeren, mehrstöckigen Gebäuden, da die Stromleitungen über weite Strecken bis zum Installationsschrank geführt werden müssen.

Daneben hat es sich in der Praxis als nachteilig herausgestellt, dass bei herkömmlichen Stromzählern die Stromleitung unterbrochen und über die Kontakte des Stromzählers geführt werden muss. Diese Kontaktierung ist nicht nur zeitaufwändig, sondern birgt auch eine potentielle Fehlerquelle, da sich Schrauben lockern können, sodass eine zeitraubende Fehlersuche erforderlich wird. Nachteilig ist ebenfalls, dass als Direktzähler ausgebildete Stromzähler üblicherweise nur für Stromstärken bis 63 Ampere vorgesehen sind. Darüber müssen so genannte Wandlerzähler eingesetzt werden, die ebenfalls einen großen Platzbedarf verursachen und bei denen ebenfalls das Problem des zeitaufwändigen Anschlusses besteht.

Herkömmliche Stromzähler sind hinsichtlich ihrer Schnittsteilen beschränkt. In den meisten Fällen ist - wenn überhaupt - lediglich eine einzige Schnittstelle vorgesehen, die jedoch nicht für alle Anwendungszwecke geeignet ist. Dementsprechend greift man in der Praxis in Abhängigkeit des jeweiligen Einsatzzwecks auf unterschiedliche Stromzähler zurück, wodurch der Planungsaufwand stark erhöht wird. Als weiterer Nachteil ist die Tatsache anzusehen, dass die Genauigkeit herkömmlicher Stromzähler gewissen Schwankungen unterliegt, sodass es schwierig ist, den Verbrauch einzelner Verbraucher prozentgenau zu ermitteln. Eine weitere Schwierigkeit entsteht dadurch, dass Stromzähler normalerweise an eine 400 V-Spannungsversorgung angeschlossen werden müssen. Der dadurch entstehende Installationsaufwand ist hoch, da eine Vorsicherung eingebaut werden muss.

Aus der US 6 538 577 B1 ist ein Stromzählermodul bekannt, umfassend ein Gehäuse, wobei das Stromzählermodul zur Messung von drei Phasen eines Drehstromkreises ausgebildet ist. Das Stromzählermodul umfasst einen Mikrocontroller zum Verarbeiten der erfassten physikalischen Größen und zum Berechnen der verbrauchten Energie, daneben umfasst das Stromzählermodul einen Kommunikationsbaustein um Informationen an ein entferntes Empfangsgerät zu übertragen.

Aus der DE 10 2007 017 985 A1 ist ein Stromzähler bekannt, der den erfassten Stromverbrauch über einen Kommunikationskanal an den Energieversorger übermittelt, sodass das manuelle Ablesen durch den Nutzer entfällt. Auch wenn dadurch bereits eine gewisse Verbesserung erreicht wird, besteht weiterhin der Nachteil, dass mit einem einzigen Stromzähler lediglich der Gesamtverbrauch einer Wohnung oder eines Gebäudes gemessen werden kann, sodass keine Informationen über einzelne Stromverbraucher oder einzelne Verbrauchsarten gewonnen werden können.

Der Erfindung liegt daher die Aufgabe zugrunde, ein Mehrfachstromzählermodul anzugeben, mit dem der Stromverbrauch unterschiedlicher Verbraucher erfasst werden kann und das gleichzeitig einen geringen Installationsaufwand erfordert.

Zur Lösung dieser Aufgabe ist ein Mehrfachstromzählermodul mit den Merkmalen des Anspruchs 1 vorgesehen.

Das erfindungsgemäße Mehrfachstromzählermodul umfasst:
- ein Gehäuse;
- mehrere in dem Gehäuse angeordnete Messstellen, die jeweils zum berührungslosen Erfassen physikalischer Größen eines durch eine Leitung fließenden Stroms ausgebildet sind, wobei jede Messstelle zur Messung der drei Phasen L1, L2, L3 eines Drehstromkreises ausgebildet ist;
- eine Eingabevorrichtung, um jeder Messstelle ein Identifikationsmerkmal zuzuordnen;
- einen Controller zum Speichern und Verarbeiten der an den einzelnen Messstellen erfassten physikalischen Größen und des jeweiligen Identifikationsmerkmals, der zum Berechnen der verbrauchten Energie aus den physikalischen Größen ausgebildet ist;
- einen Kommunikationsbaustein, um die von dem Controller berechneten physikalischen Größen und das jeweils zugeordnete Identifikationsmerkmal über eine Kommunikationsschnittstelle einer Auswerteeinheit als Ausgabedaten zur Verfügung zu stellen.

Das erfindungsgemäße Mehrfachstromzählermodul umfasst ein kompaktes Gehäuse, sodass der Platzbedarf in einem Installationsschrank wesentlich geringer ist im Vergleich zur Verwendung herkömmlicher separater Stromzähler. In dem Gehäuse sind mehrere Messstellen angeordnet, mit denen physikalische Größen des durch eine Leitung fließenden Stroms berührungslos gemessen werden können. Auf diese Weise entfällt das aufwändige und fehleranfällige Unterbrechen der Stromleitungen. Mit der erfindungsgemäß vorgesehenen Eingabevorrichtung kann jeder Messstelle ein Identifikationsmerkmal zugeordnet werden, das beispielsweise die Bedeutung einer Kostenstelle hat. Der erfindungsgemäß vorgesehene Controller speichert und verarbeitet die an den einzelnen Messstellen erfassten physikalischen Größen, um daraus weitere physikalische Größen abzuleiten, beispieisweise die verbrauchte Energie oder die Leistung oder den zeitlichen Verlauf dieser Größen. Da die Erfassung der physikalischen Größen unmittelbar in dem Mehrfachstromzählermodul erfolgt, kann eine wesentlich höhere Messgenauigkeit erreicht werden im Vergleich zur Verwendung separater Stromzähler. Wesentlich ist dabei, dass die Messstellen des Mehrfachstromzählermoduls jeweils zur Messung der drei Phasen L1, L2, L3 einer Leitung eines Drehstromkreises ausgebildet sind. Durch die Messung der drei Phasen (Leiter) werden sämtliche erforderlichen physikalischen Größen erfasst, die ausgewertet und weiter verarbeitet werden können. Vorzugsweise weist das Mehrfachstromzählermodul drei Messstellen auf, daneben sind jedoch auch Ausführungen mit vier, fünf, zehn oder einer noch größeren Anzahl an Messstellen möglich. Das erfindungsgemäße Mehrfachstromzählermodul weist eine kompakte Größe auf, die die Montage in einem Schaltschrank erleichtert, daher kann es auch einfach bei bestehenden Installationen nachgerüstet werden.

Bei dem erfindungsgemäßen Mehrfachstromzählermodul kann eine Messstelle um eine das Gehäuse durchsetzende Ausnehmung herum angeordnet sein, durch die ein Leiter führbar ist.

Gemäß einer Weiterentwicklung der Erfindung kann es vorgesehen sein, dass eine Messstelle eine Rogowski-Spule aufweist, durch die eine Leitung führbar ist. Mit einer derartigen Rogowski-Spule kann eine besonders hohe Messgenauigkeit erzielt werden. Insbesondere kann eine Rogowski-Spule bei dem erfindungsgemäßen Mehrfachstromzählermodul um eine das Gehäuse durchsetzende Ausnehmung herum angeordnet sein, durch die eine Leitung führbar ist. Die Ausnehmungen in dem Gehäuse sind vorzugsweise kreisförmig ausgebildet. Bei der Installation genügt es somit, die zu messende Leitung durch die in dem Gehäuse des Mehrfachstromzählermoduls vorgesehene Ausnehmung durchzuführen, wobei für jede Phase bzw. für jeden Leiter der Leitung des Drehstromkreises eine Ausnehmung vorgesehen ist. Auf ein Unterbrechen der Leitungen und ein umständliches und fehleranfälliges Kontaktieren kann hingegen verzichtet werden.

Es liegt auch im Rahmen der Erfindung, dass eine Messstelle des erfindungsgemäßen Mehrfachstromzählermoduls zum Erfassen des Stroms, der Spannung und gegebenenfalls des Phasenwinkels als physikalische Größen ausgebildet ist, wobei zumindest der Strom berührungslos gemessen wird. Aus diesen physikalischen Grundgrößen können abgeleitete Größen errechnet werden, beispielsweise die elektrische Leistung, die verbrauchte elektrische Energie und dergleichen.

Es ist zweckmäßig, dass eine Messstelle des erfindungsgemäßen Mehrfachstromzählermoduls zum Erfassen der physikalischen Größen in festgelegten oder festlegbaren Zeitintervallen ausgebildet ist. Auf diese Weise werden in festgelegten Zeitintervallen die Messwerte erfasst und entweder direkt von der Messstelle oder für alle Messstellen in dem Controller erfasst. Der Controller dient dabei als Datenlogger und speichert die erfassten Messdaten, die zu einem späteren Zeitpunkt ausgewertet werden können. Allen erfassten Messdaten wird dabei eine Zeitinformation zugeordnet, um die Messdaten zeitabhängig auswerten zu können. Daher können einzelne zeitlich begrenzte Ereignisse untersucht und ausgewertet werden, zusätzlich können Stromverbräuche über längere, festgelegte Zeiträume ermittelt werden.

Bei dem erfindungsgemäßen Mehrfachstromzählermodul kann es auch vorgesehen sein, dass die Spannungsversorgung durch wenigstens eine der zu messenden Leitungen bereitgestellt wird. Eine einzige Spannungsversorgung bzw. ein einziger Spannungsanschluss stellt die Energieversorgung für die mehreren, z. B. vier, Drehstrommessungen zur Verfügung. Insbesondere kann die Spannungsversorgung mittels Einsteckschrauben oder Kontaktierungsschrauben bereitgestellt werden, die in die zu messenden Leitungen durch Einschrauben gebohrt werden können, wodurch die Spannungsversorgung für das gesamte Mehrfachstromzählermodul sichergestellt wird. Die Einsteckschrauben sind in dem Gehäuse im Bereich der Ausnehmungen befestigt und werden nach dem Durchführen des Leiters (Phase) der Leitung in diese eingeschraubt. Der Leiter (Phase) kann mit einer Zentrierhülse versehen sein, sodass der Leiter in der Ausnehmung zentriert wird.

Der in dem Mehrfachstromzählermodul vorgesehene Kommunikationsbaustein kann eine Schnittstelle für einen M-Bus und/oder wenigstens einen Impulsausgang aufweisen. Über den M-Bus bzw. den Impulsausgang können Daten der Messstellen und/oder des Controllers an ein entferntes Gerät übertragen werden. Andererseits kann das Mehrfachstromzählermodul von dem entfernten Gerät über den Kommunikationsbaustein ausgelesen werden. Alternativ oder zusätzlich kann der Kommunikationsbaustein einen Webserver aufweisen, um die Ausgabedaten der Auswerteeinheit zur Verfügung zu stellen. Dabei wird es besonders bevorzugt, dass der Webserver mit der Auswerteeinheit über ein Modem, ein DSL-Modem oder ein GSM-Modem verbindbar oder verbunden ist. Die Daten können auch über das Internet, insbesondere in den Formaten Http, Https oder mit dem Protokoll FTP versendet bzw. abgerufen werden. Als weiteres Format für die zu übertragenden Daten kommt XML in Frage. Die zu versendenden oder abzurufenden Daten können wahlweise verschlüsselt oder unverschlüsselt übertragen werden. Die Möglichkeit der Datenübertragung über das Internet erweitert die Kommunikationsmöglichkeiten zwischen dem Mehrfachstromzählermodul und der externen Auswerteeinheit.

Es liegt auch im Rahmen der Erfindung, dasss die bei dem erfindungsgemäßen Mehrfachstromzählermodul vorgesehene Eingabevorrichtung als Drehschalter ausgebildet ist. Mit dem Drehschalter kann jeder Messstelle ein Identifikationsmerkmal zugeordnet werden, um sämtliche von dieser Messstelle erfassten physikalischen Größen zu kennzeichnen, wobei das Identifikationsmerkmal eine Kostenstelle bezeichnen kann. Es ist zweckmäßig, wenn jede Messstelle eine derartige Eingabevorrichtung aufweist. Die Einstellung des Identifikationsmerkmals ist besonders einfach, wenn die Eingabevorrichtung als Drehschalter ausgebildet ist. Alternativ kann die Eingabevorrichtung auch als Tastschalter ausgebildet sein, ebenfalls ist eine Zehnertastatur denkbar.

Bei dem erfindungsgemäßen Mehrfachstromzählermodul kann es vorgesehen sein, dass das mittels der Eingabevorrichtung eingegebene Identifikationsmerkmal an einer Anzeige anzeigbar ist. Die Anzeige kann als Siebensegmentanzeige, als LCD-Anzeige oder als Punktmatrixanzeige ausgebildet sein.

Es ist möglich, mehrere erfindungsgemäße Mehrfachstromzählermodule über eine Datenleitung miteinander zu verbinden. Die Mehrfachstromzählermodule können wahlweise sternförmig oder strangförmig (in Reihe) verbunden sein. Wenn mittels der Eingabevorrichtungen der Mehrfachstromzählermodule das gleiche Identifikationsmerkmal eingegeben wird, das einer Kostenstelle entspricht, kann durch einen Controller oder eine Auswerteeinheit automatisch die Summe des Stromverbrauchs dieser Kostenstelle gespeichert und ausgewertet werden, indem die von den einzelnen Mehrfachstromzählermodulen ermittelten Verbräuche addiert werden. Somit kann der Gesamtverbrauch einer Kostenstelle ermittelt werden, der mittels mehrerer oder vieler Mehrfachstromzählermodule erfasst worden ist.

Weitere Vorteile und Einzelheiten der Erfindung werden anhand eines Ausführungsbeispiels unter Bezugnahme auf die Zeichnungen erläutert. Die Zeichnungen sind schematische Darstellungen und zeigen:
- Fig. 1: ein erfindungsgemäßes Mehrfachstromzählermodul in einer Draufsicht;
- Fig. 2: das Mehrfachstromzählermodul von Fig. 1 in einer perspektivischen Ansicht;
- Fig. 3: eine Seitenansicht des Mehrfachstromzählermoduls von Fig. 1; und
- Fig. 4: eine Schaltungsplatine für das Mehrfachstromzählermodul.

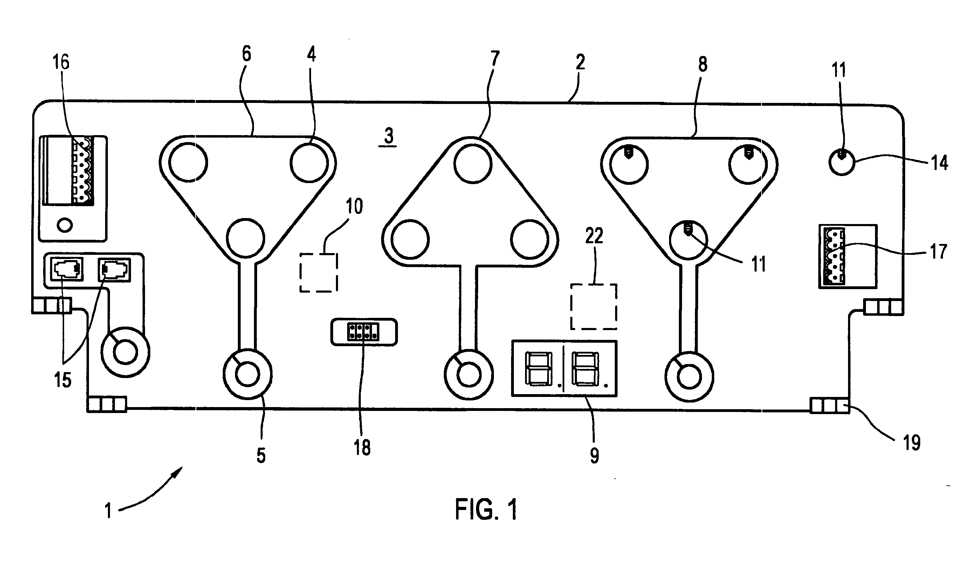

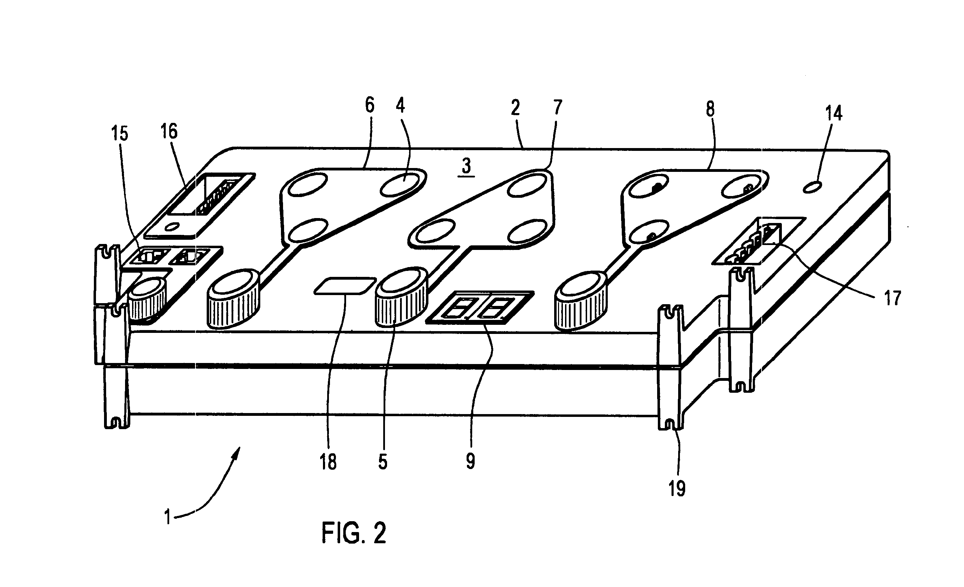

Wie am besten in den Figuren 1 und 2 zu erkennen ist, umfasst das Mehrfachstromzählermodul 1 ein im Wesentlichen quaderförmiges Gehäuse 2, das in dem dargestellten Ausführungsbeispiel für drei Messstellen 6, 7, 8 vorgesehen ist, wobei jede Messstelle 6, 7, 8 zur Messung der drei Phasen L1, L2, L3 einer Leitung eines Drehstromkreises ausgebildet ist. Die Oberseite 3 des Gehäuses 2 weist in dem dargestellten Ausführungsbeispiel kreisförmige Ausnehmungen 4 auf, die in Dreiergruppen angeordnet sind. Durch diese Ausnehmungen 4 werden die Phasen L1, L2, L3 einer zu messenden Stromleitung geführt, um physikalische Größen mit hoher Genauigkeit zu messen. Mit den drei Messstellen 6, 7, 8 des Mehrfachstromzählermoduls 1 können somit die physikalischen Größen der Leitungen von drei Drehstromkreisen erfasst werden, wobei jede der Leitungen drei Phasen L1, L2, L3 umfasst. Die Ausnehmungen 4 erstrecken sich jeweils senkrecht von der Oberseite 3 bis zur Rückseite bzw. Unterseite des Gehäuses 2. Die Messung der physikalischen Größen erfolgt mit in Fig. 1 nicht sichtbaren Rogowski-Spulen, die eine berührungslose Messung des Stroms ermöglichen. Jeweils drei zueinander gehörenden Ausnehmungen 4 ist eine als Drehschalter 5 ausgebildete Eingabevorrichtung zugeordnet, um jeder Messstelle 6, 7, 8 ein Identifikationsmerkmal zuordnen zu können. Das jeweils eingestellte Identifikationsmerkmal ist auf einer als Siebensegmentanzeige 9 ausgebildeten Anzeige sichtbar.

Pro Messstelle 6, 7, 8 erfasst ein integrierter Schaltkreis mit einem Analog-DigitalWandler Ströme, Spannungen und Phasenwinkel des durch die Leitungen in den Ausnehmungen 4 fließenden Stroms. Aus diesen teilweise berührungslos erfassten physikalischen Größen, wobei zumindest der Strom berührungslos gemessen wird, können abgeleitete physikalische Größen errechnet werden wie die Energie oder die Leistung. Ein in Fig. 1 schematisch dargestellter, in dem Gehäuse 2 angeordneter Controller 10 ist mit den Messstellen 6, 7, 8 verbunden und speichert und verarbeitet die an den einzelnen Messstellen erfassten physikalischen Größen. Dementsprechend ist das Mehrfachstromzählermodul 1 in der Lage, Strom, Spannung und daraus abgeleitete Größen der Leitungen von drei Drehstromkreisen zu erfassen. Zu jeder erfassten physikalischen Größe wird auch das mittels der Drehschalter 5 eingestellte Identifikationsmerkmal gespeichert.

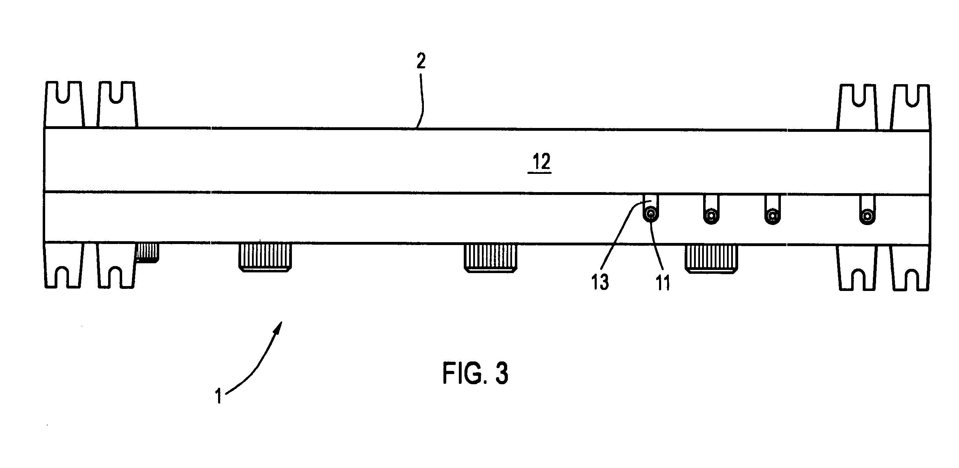

Die Ausnehmungen 4 der Messstelle 8 weisen Einsteckschrauben 11 oder Kontaktierungsschrauben auf, die von der in Fig. 3 gezeigten Seitenfläche 12 des Gehäuses 2 zugänglich sind. An dieser Seite weist das Gehäuse 2 Öffnungen 13 auf, über die die Einsteckschrauben 11 zugänglich sind, um diese mit einem Schraubwerkzeug in ein durch die Ausnehmung 4 geführtes Kabel zu bohren. Über diese Kontaktierung wird die Spannungsversorgung für das Mehrfachstromzählermodul 1 sichergestellt, indem die benötigte Spannung den zu messenden Leitungen entnommen wird. In die Ausnehmung 4 kann eine Zentrierhülse gesteckt werden, sodass auch dünnere Leitungen sicher kontaktiert werden können. Eine weitere Ausnehmung 14 mit einer Einsteckschraube 11 ist für den Neutralleiter (N) vorgesehen.

Auf der Oberseite 3 des Gehäuses 2 befinden sich zwei Buchsen 15, um das Mehrfachstromzählermodul 1 an ein Netzwerk anzuschließen. In dem dargestellten Ausführungsbeispiel kann mittels der Buchsen 15 der Anschluss an einen M-Bus realisiert werden, wobei die Buchsen 15 als Eingang und Ausgang dienen. Weiterhin sind zwei Anschlüsse 16, 17 vorhanden, um externe Wandlerzähler (Stromwandler) anzuschließen. Zusätzlich weist das Mehrfachstromzählermodul 1 einen Impulsausgang 18 auf, um die Messwerte einer externen Auswerteeinheit in Impulsform zur Verfügung zu stellen.

In Fig. 2 erkennt man, dass das Gehäuse 2 U-förmig ausgebildete Montsgevorsprünge 19 aufweist, die sich an der Oberseite 3 und der gegenüberliegenden Rückseite erstrecken, um das Gehäuse 2 am Einbauort festzuschrauben.

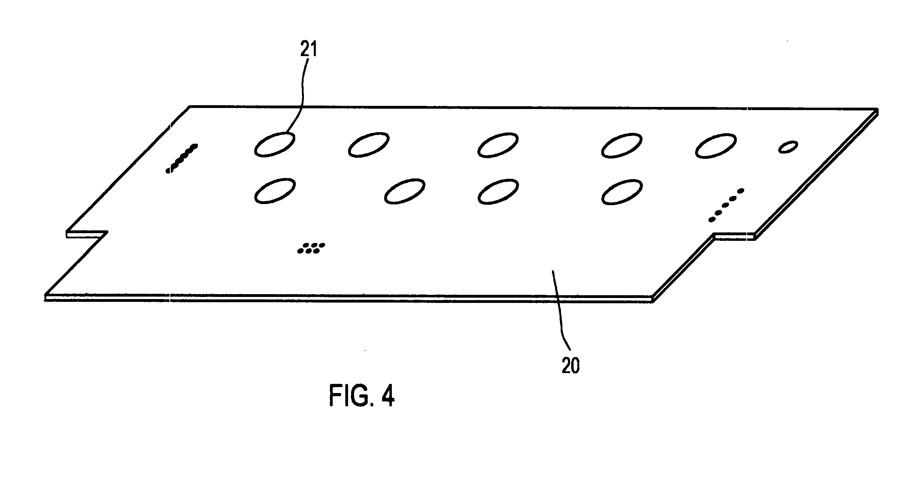

Fig. 4 zeigt schematisch die in dem Mehrfachstromzählermodul 1 eingebaute Schaltungsplatine 20 vor der Montage der elektrischen und elektronischen Bauteile. Die Platine weist eine Mehrzahl von Löchern 21 auf, deren Position und Größe jeweils an die entsprechende Ausnehmung 4 angepasst ist. Die zu messenden Leitungen sind somit durch die Ausnehmungen 4 und die Löcher 21 in der Schaltungsplatine 20 geführt.

Nach dem Einbau des Mehrfachstromzählermoduls 1 in einen Installationsschrank werden die zu messenden Leitungen durch die Ausnehmungen 4 geführt. Die Spannungsversorgung für das Mehrfachstromzählermodul 1 wird über die Messstelle 8, die die Einsteckschrauben 11 oder die Kontaktienungsschrauben aufweist, realisiert.

Die einzelnen Messstellen 6, 7, 8, die jeweils zur Messung der drei Phasen L1, L2, L3 einer Leitung eines Drehstromkreises ausgebildet sind, erfassen mittels der Rogowski-Spulen berührungslos den Strom, daneben werden die Spannung und der Phasenwinkel gemessen, um aus diesen physikalischen Größen die verbrauchte elektrische Energie zu ermitteln. Der Controller 10 speichert und verarbeitet die an den einzelnen Messstellen 6, 7, 8 erfassten physikalischen Größen in festgelegten Zeitintervallen. Jeder physikalischen Größe wird dabei ein Identifikationsmerkmal, beispielsweise eine Zahl, zugeordnet, das mittels des Drehschalters 5 eingestellt werden kann. Diese Einstellung wird normalerweise direkt beim Einbau des Mehrfachstromzählermoduls vorgenommen und muss anschließend nicht wieder geändert werden. Über eine Messstelle können auch mehrere Verbraucher überwacht werden, indem die zugehörigen Leitungen durch die Messstelle geführt werden. Bezogen auf das in den Zeichnungen gezeigte Ausführungsbeispiel kann die Messstelle 6 beispielsweise für die Beleuchtung, die Messstelle 7 für die Messung des Stromverbrauchs von Klimaanlagen und die Messstelle 8 für die Messung des Stromverbrauchs von elektrischen Geräten in einem gewerblich genutzten Gebäude verwendet werden.

Die Controller 10 speichert und verarbeitet die von den einzelnen Messstellen erfassten Messdaten, sodass diese über einen Kommunikationsbaustein, der in dem dargestellten Ausführungsbeispiel als Webserver 22 ausgebildet ist, über eine Kommunikationsschnittstelle einer Auswerteeinheit zur Verfügung gestellt werden können. Das Mehrfachstromzählermodul 1 ist über den Webserver 22 mit einer externen Auswerteeinheit verbunden, die entsprechenden Netzwerkkabel werden dazu in die Buchsen 15 gesteckt. Bei anderen Ausführungen kann die Verbindung des Webservers 22 mit der externen Auswerteeinheit auch drahtlos erfolgen, beispielsweise über ein GSM-Modem.

Die Auswerteeinheit kann ein PC oder eine Leitstelle sein, an der vielfältige Datenanalysen vorgenommen werden können. Einerseits kann über die Kommunikationsschnittstelle auf die von dem Controller gespeicherten Daten zugegriffen werden, darüber hinaus kann der Webserver 22 Daten oder bestimmte Datenauswertungen über die Kommunikationsschnittstelle an die externe Auswerteeinheit senden. Der Webserver 22 kann auch so konfiguriert werden, dass er beim Eintritt bestimmter Ereignisse automatisch eine Meldung an die Auswerteeinheit sendet. Ein solches Ereignis kann die Überschreitung oder die Unterschreitung eines bestimmten Werts für den Stromverbrauch sein. Mittels der Auswerteeinheit können die aktuellen Messwerte auch in Echtzeit verfolgt werden. Alternativ kann die Auswerteeinheit auch ein Mobiltelefon sein, an das die Daten gesendet werden. Die Daten können dann auf dem Mobiltelefon ausgewertet und eingesehen werden. Da für die Daten ein Standardformat verwendet wird, beispielsweise XML, Http oder dergleichen, ist für die Auswertung und Darstellung der Daten keine besondere Zusatzsoftware erforderlich, sodass die Darstellung der Daten mit einem herkömmlichen Webbrowser eines PCs oder mit einem dafür geeigneten Mobiltelefon oder einem Organizer erfolgen kann.

## Patentansprüche

1. Mehrfachstromzählermodul (1), umfassend
- ein Gehäuse (2);
- mehrere in dem Gehäuse angeordnete Messstellen (6, 7, 8), die jeweils zum berührungslosen Erfassen physikalischer Größen eines durch eine Leitung fließenden Stroms ausgebildet sind, wobei jede Messstelle (6, 7, 8) zur Messung der drei Phasen L1, L2, L3 eines Drehstromkreises ausgebildet ist;
- eine Eingabevorrichtung, um jeder Messstelle ein Identifikationsmerkmal zuzuordnen;
- einen Controller (10) zum Speichern und Verarbeiten der an den einzelnen Messstellen (6, 7, 8) erfassten physikalischen Größen und des jeweiligen Identifikationsmerkmals, der zum Berechnen der verbrauchten Energie aus den physikalischen Größen ausgebildet ist;
- einen Kommunikationsbaustein, um die von dem Controller berechneten physikalischen Größen und das jeweils zugeordnete Identifikationsmerkmal über eine Kommunikationsschnittstelle einer Auswerteeinheit als Ausgabedaten zur Verfügung zu stellen.

2. Mehrfachstromzählermodul nach Anspruch 1, **dadurch gekennzeichnet, dass** eine Messstelle (6, 7, 8) um eine das Gehäuse (2) durchsetzende Ausnehmung, durch die ein Leiter führbar ist, herum angeordnet ist.

3. Mehrfachstromzählermodul nach Anspruch 1 oder 2, **dadurch gekennzeichnet, dass** eine Messstelle (6, 7, 8) eine Rogowski-Spule aufweist.

4. Mehrfachstromzählermodul nach Anspruch 2 oder 3, **dadurch gekennzeichnet, dass** eine Ausnehmung (4) kreisförmig ausgebildet ist.

5. Mehrfachstromzählermodul nach einem der vorangehenden Ansprüche, **dadurch gekennzeichnet, dass** eine Messstelle (6, 7, 8) zum Erfassen des Stroms, der Spannung und gegebenenfalls des Phasenwinkels als physikalische Größen ausgebildet ist, wobei zumindest die Strommessung berührungslos erfolgt.

6. Mehrfachstromzählermodul nach einem der vorangehenden Ansprüche, **dadurch gekennzeichnet, dass** die Messstelle (6, 7, 8) zum Erfassen der physikalischen Größen in festgelegten oder festlegbaren Zeitintervallen ausgebildet ist.

7. Mehrfachstromzählermodul nach einem der vorangehenden Ansprüche, **dadurch gekennzeichnet, dass** die Spannungsversorgung für das Mehrfachstromzählermodul (1) durch wenigstens eine der zu messenden Leitungen bereitgestellt wird.

8. Mehrfachstromzählermodul nach Anspruch 7, **dadurch gekennzeichnet, dass** es in Leitungen bohrbare Einsteckschrauben (11) oder Kontaktierungsschrauben aufweist, um die Spannungsversorgung für das Mehrfachstromzählermodul (1) sicherzustellen.

9. Mehrfachstromzählermodul nach einem der vorangehenden Ansprüche, **dadurch gekennzeichnet, dass** der Kommunikationsbaustein eine Schnittstelle für einen M-Bus und/oder wenigstens einen Impulsausgang aufweist.

10. Mehrfachstromzählermodul nach einem der vorangehenden Ansprüche, **dadurch gekennzeichnet, dass** der Kommunikatiunsbaustein einen Webserver (22) aufweist, um die Ausgabedaten der Auswerteeinheit zur Verfügung zu stellen.

11. Mehrfachstromzählermodul nach Anspruch 10, **dadurch gekennzeichnet, dass** der Webserver (22) mit der Auswerteeinheit über ein Modem, ein DSL-Modem oder ein GSM-Modem verbindbar oder verbunden ist.

12. Mehrfachstromzählermodul nach einem der vorangehenden Ansprüche, **dadurch gekennzeichnet, dass** die Eingabevorrichtung als Drehschalter (5) ausgebildet ist.

13. Mehrfachstromzählermodul nach Anspruch 12, **dadurch gekennzeichnet, dass** das mittels der Eingabevorrichtung eingegebene Identifikationsmerkmal an einer Anzeige (9) anzeigbar ist.

## Claims

1. A multiple current-meter module (1), comprising
- a housing (2);
- several test points (6, 7, 8) arranged within the housing, which are each embodied for the contact-free registration of physical parameters of a current flowing through a line,
wherein each test point (6, 7, 8) is embodied to measure the three phases L1, L2, L3 of a three-phase circuit;
- an entry device for assigning an identification feature to each test point;
- a controller (10) for storage and processing of the physical parameters registered at the individual test points (6, 7, 8) and the respective identification feature, which is embodied to calculate the energy consumed from the physical parameters;
- a communications module for supplying the physical parameters calculated by the controller and the respectively assigned identification feature via a communications interface to an evaluation unit as output data.

2. The multiple current-meter module according to claim 1,
**characterised in that**
a test point (6, 7, 8) is arranged around a recess passing through the housing (2), through which a conductor can be guided.

3. The multiple current-meter module according to claim 1 or 2,
**characterised in that**
a test point (6, 7, 8) provides a Rogowski coil.

4. The multiple current-meter module according to claim 2 or 3,
**characterised in that**
a recess (4) is embodied to be circular.

5. The multiple current-meter module according to any one of the preceding claims,
**characterised in that**
a test point (6, 7, 8) is embodied to register the current, the voltage and optionally the phase angle as physical parameters, wherein at least the current measurement is implemented in a contact-free manner.

6. The multiple current-meter module according to any one of the preceding claims,
**characterised in that**
the test point (6, 7, 8) is embodied to register the physical parameters at fixed or fixable time intervals.

7. The multiple current-meter module according to any one of the preceding claims,
**characterised in that**
the voltage supply for the multiple current-meter module (1) is provided by at least one of the lines to be measured.

8. The multiple current-meter module according to claim 7, **characterised in that**
it provides plug-in screws (11) capable of being screwed into lines or contact screws in order to secure the voltage supply for the multiple current-meter module (1).

9. The multiple current-meter module according to any one of the preceding claims,
**characterised in that**
the communications module provides an interface for an M-bus and/or at least one pulse output.

10. The multiple current-meter module according to any one of the preceding claims,
**characterised in that**
the communications module provides a web server (22) for supplying the output data to the evaluation unit.

11. The multiple current-meter module according to claim 10,
**characterised in that**
the web server (22) can be connected or is connected to the evaluation unit via a modem, a DSL modem or an GSM modem.

12. The multiple current-meter module according to any one of the preceding claims,
**characterised in that**
the input device is embodied as a rotary switch (5).

13. The multiple current-meter module according to claim 12,
**characterised in that**
the identification feature entered by means of the entry device can be displayed on a display (9).

## Revendications

1. Module de compteur à flux multiples (1) comprenant :
- un logement (2) ;
- plusieurs points de mesure (6, 7, 8) agencés dans le logement qui sont chacun réalisés en vue de la détermination sans contact de valeurs physiques d'un flux circulant dans une conduite, chaque point de mesure (6, 7, 8) étant réalisé en vue de la mesure des trois phases L1, L2, L3 d'un circuit de courant triphasé ;
- un dispositif d'entrée destiné à attribuer une caractéristique d'identification à chaque point de mesure ;
- un contrôleur (10) destiné à enregistrer et à traiter les valeurs physiques déterminées aux points de mesure (6, 7, 8) individuels et la caractéristique d'identification respective qui est conçue afin de calculer l'énergie consommée sur la base des valeurs physiques ;
- un composant de communication destiné à mettre les valeurs physiques calculées par le contrôleur et la caractéristique d'identification attribuée à chaque fois à la disposition d'une unité d'analyse sous la forme de données de sortie par le biais d'une interface de communication.

2. Module de compteur à flux multiples selon la revendication 1, **caractérisé en ce qu'**un point de mesure (6, 7, 8) est agencé autour d'un évidement pratiqué dans le logement (2) à travers lequel un conducteur peut être introduit.

3. Module de compteur à flux multiples selon la revendication 1 ou 2, **caractérisé en ce qu'**un point de mesure (6, 7, 8) présente un enroulement de Rogovski.

4. Module de compteur à flux multiples selon la revendication 2 ou 3, **caractérisé en ce qu'**un évidement (4) est réalisé dans une forme circulaire.

5. Module de compteur à flux multiples selon l'une des revendications précédentes, **caractérisé en ce qu'**un point de mesure (6, 7, 8) est réalisé en vue de la détermination du courant, de la tension, et le cas échéant de l'angle de phase en tant que valeurs physiques, étant entendu qu'au moins la mesure du courant est réalisée sans contact.

6. Module de compteur à flux multiples selon l'une des revendications précédentes, **caractérisé en ce que** les points de mesure (6, 7, 8) sont réalisés de manière à déterminer des valeurs physiques à intervalles de temps définis ou pouvant être définis.

7. Module de compteur à flux multiples selon l'une des revendications précédentes, **caractérisé en ce que** l'alimentation électrique pour le module de compteur à flux multiples (1) est fournie par au moins une des conduites devant être mesurées.

8. Module de compteur à flux multiples selon la revendication 7, **caractérisé en ce qu'**il présente dans des conduites des vis à emboîtement pouvant être forées (11) ou des vis de contact afin de garantir l'alimentation électrique pour le module de compteur à flux multiples (1).

9. Module de compteur à flux multiples selon l'une des revendications précédentes, **caractérisé en ce que** le composant de communication présente une interface pour un bus M et/ou au moins une sortie d'impulsions.

10. Module de compteur à flux multiples selon l'une des revendications précédentes, **caractérisé en ce que** le composant de communication présente un serveur web (22) afin de mettre les données de sortie à la disposition de l'unité d'analyse.

11. Module de compteur à flux multiples selon la revendication 10, **caractérisé en ce que** le serveur web (22) est relié ou peut être relié à l'unité d'analyse au moyen d'un modem, d'un modem DSL ou d'un modem GSM.

12. Module de compteur à flux multiples selon l'une des revendications précédentes, **caractérisé en ce que** le dispositif d'entrée est réalisé comme interrupteur rotatif (5).

13. Module de compteur à flux multiples selon la revendication 12, **caractérisé en ce que** la caractéristique d'identification introduite au moyen du dispositif d'entrée peut être affichée sur un cadran (9).
